# EUROPEAN PATENT APPLICATION

(11) **EP 4 704 147 A1**
(43) Date of publication of application: **04.03.2026**
(21) Application number: 24197345.2
(22) Date of filing: 29.08.2024
(51) Int. Cl.: H01L 23/051, H01L 23/62, H01L 25/07

(54) **POWER SEMICONDUCTOR MODULE AND METHOD FOR CREATING A CURRENT BYPASS IN THE POWER SEMICONDUCTOR MODULE**

(71) Applicant: Hitachi Energy Ltd, 8050 Zürich (CH)
(72) Inventor: Beyer, Harald, 5600 Lenzburg (CH); Guillon, David, 8857 Vorderthal (CH); Santolaria, Lluis, 4600 Olten (CH)
(74) Representative: Epping - Hermann - Fischer

(57) **Abstract**

A power semiconductor module (100), comprising a top plate (10) extending along an extension area (A1), having a first main surface (11) and a second main surface (12) opposite the first main surface (11) in a stacking direction (S1). The power semiconductor module (100) further comprises a substrate (20), having a third main surface (21) and a fourth main surface (22) opposite the third main surface (21) in the stacking direction (S1), wherein the second main surface (12) faces the third main surface (21). A chip (30) with at least one top side contact (31), arranged on the third main surface (21), wherein the at least one top side contact (31) faces the second main surface (12). The power semiconductor module (100) further comprises a pressure contact (50) arranged in the stacking direction (S1) between the top plate (10) and the chip (30), wherein the at least one top side contact (31) of the chip (30) is electrically connected to the top plate (10) by the pressure contact (50), and wherein the pressure contact (50) comprises a contact layer (60) configured to melt due to elevated temperatures generated by high current in case of a short-circuit situation, and to flow across the chip (30), such that a current bypass over the chip (30) to the substrate (20) is created. Meanwhile the pressure contact (50) maintains a pressure on the chip (30) due to a spring force of the pressure contact (50) and maintains an electrical connection to the chip (30).

## Description

The present disclosure relates to a power semiconductor module. The present disclosure further relates to a method for creating a current bypass in the power semiconductor module.

Power semiconductor modules with multiple individual switching elements are a widely used type of power semiconductor module, for example in high-voltage direct current (HVDC) applications, where multiple power modules are arranged in a stack providing a serial connection of the power modules. On a submodule of a power semiconductor module with pressure contacts multiple chips are soldered to a baseplate and are individually connected with a top plate by the pressure contacts.

It is an object to provide a power semiconductor module with an enhanced short-circuit capability.

This object is solved by the features of the independent claims. Advantageous embodiments are indicated in the dependent claims.

Embodiments of the disclosure, for instance as claimed in the independent claims, address the above shortcomings in the art in whole or in part. Further embodiments of the power semiconductor module and of the method for creating a current bypass in the power semiconductor module are subject matter of the further claims.

There is provided a power semiconductor module. The power semiconductor module comprises a top plate extending along an extension area. The extension area has a first main surface and a second main surface opposite the first main surface in a stacking direction. The power semiconductor module further comprises a substrate. The substrate has a third main surface and a fourth main surface. The fourth main surface is opposite the third main surface in the stacking direction. The second main surface faces the third main surface. The substrate may be a simple metal base plate, an insulated metal substrate, comprising a metal plate, an isolating sheet, and a circuit metallization, or a ceramic substrate consisting of an isolating ceramic sheet with top and bottom metallization. A chip is arranged on the third main surface. The chip has at least one top side contact. The number of top side contacts is not limited to one and the chip can have more than one top side contact. The at least one top side contact faces the second main surface.

A pressure contact is arranged in the stacking direction between the top plate and the chip. The at least one top side contact of the chip is electrically connected to the top plate by the pressure contact.

The pressure contact comprises a contact layer, which is configured to melt in case of a short-circuit situation, in particular due to elevated temperatures generated by a high current through the power semiconductor module, in particular a terminal, and in particular the chip. The material of the contact layer flows in its molten state across the chip, creating a current bypass over the chip to the substrate.

In a short-circuit situation accompanied by high temperature generation, the material of the contact layer is melting and flowing down towards the chip. The material of the contact layer provides a conductive coating of the chip and consequently an electrical short or bypass across the chip between the pressure contact and the substrate, e.g. baseplate. In this manner a low-Ohmic electrical connection is created between a terminal of the pressure contact and the substrate. Thus, a power semiconductor module with a significantly enhanced current rating in normal operation and a significantly enhanced short-circuit capability of up to 5,000 A is provided.

The additional body of the conductive material of the contact layer also acts as a heat buffer, which prevents the pressure contact from melting, until the current bypass over the chip is formed. This enhances the endurance of the power semiconductor module in the short-circuit situation.

In the meantime, the pressure contact maintains a pressure on the chip due to a spring force of the pressure contact. Due to the exerted pressure, the pressure contact maintains an electrical connection to the chip, both in normal operation, i.e., prior to melting of the material of the contact layer, and in the short-circuit situation, i.e., after melting of the material of the contact layer.

The pressure contact comprises for example a presspin body and a spring. The presspin body has a first thickness in the stacking direction and is electrically connected to the chip. The spring is configured to apply pressure on the presspin body in the stacking direction towards the chip. Optionally, the spring carries the current. The spring is electrically contacted to the top plate. The presspin body is for example formed as a kind of a stamp, which is pressed against the chip surface. The presspin body has for example a first thick portion, e.g., for providing an electrical contact with the chip or contact layer, and a second thinner pin-shaped portion, where the spring is arranged in a surrounding manner. The structure of the pressure contact is not limited to the described example. Other setups of the pressure contact are also possible.

According to an embodiment, the pressure contact comprises the presspin body with the first thickness in the stacking direction. The first thickness is for example the length of the presspin body which extends in the stacking direction. The presspin body is electrically connected to the chip. The pressure contact further comprises a bracket. The bracket comprises for example two leaves mainly extending in the stacking direction. The bracket is arranged besides the spring and/or presspin body in the extension area. The bracket is configured to be used as current conductor, which is electrically connected to the presspin body and the top plate. The pressure contact further comprises the spring for applying pressure on the presspin body in the stacking direction towards the chip.

The pressure contact may incorporate more parts like washers or spacers and is not limited to the mentioned parts.

According to an embodiment a first part of the contact layer is arranged between the chip and the presspin body.

The contact layer is for example arranged in the current path, e.g. between the chip surface and the presspin body. In case of a short-circuit, the body of the low melting material of the contact layer is molten. Due to the strong spring force of 700-800 N, the molten material is squeezed out of the terminal structure and flows over the chip surface and the sidewalls of the chip forming a current path. The sidewalls of the chip are extending in the stacking direction.

According to a further embodiment the value of a second thickness of the first part of the contact layer in the stacking direction is in the range between 0.5 mm and 15 mm.

The second thickness of the contact layer is for example the length of the contact layer, which extends in the stacking direction. The contact layer needs sufficient material, which can be melted due to the high temperatures generated by the high currents during a short-circuit situation. On the other hand, due to space saving requirements, height limitations and/or a maximum spring path of the pressure contact the second thickness should not be too large.

Preferably, the dimensions of the contact layer along the extension area are equal to the dimensions of the presspin body along the extension area. Alternatively, the dimensions of the contact layer along the extension area are larger than the dimensions of the presspin body along the extension area, such that, for example, the contact layer may protrude from the perimeter of the presspin body or even from the perimeter of the chip. Alternatively, the dimensions of the contact layer along the extension area are smaller than the dimensions of the presspin body along the extension area.

The shape of the contact layer, when viewed in the stacking direction can be circular or rectangular. Other shapes may also be possible. The contact layer has for example a shape, when viewed in the stacking direction, which corresponds to the cross-sectional shape of the presspin body, when viewed in the stacking direction. Alternatively, the contact layer has for example a shape, when viewed in the stacking direction, which corresponds to the shape or outer dimensions of the chip, when viewed in the stacking direction.

According to a further embodiment, alternatively or in addition, a second part of the contact layer is arranged along the extension area in a circumferential manner around the presspin body.

The contact layer is for example arranged around the presspin body, e.g. covering an outer surface, such as a cylindrical surface of the presspin. In other words, the contact layer extends along the extension area beyond the perimeter of the presspin body and/or outside the perimeter of the chip. For example, a part of the contact layer may be arranged in an outer part of the at least one top side contact and/or chip not covered by the presspin body, i.e., be laterally or horizontally offset with respect to the center of the presspin body. This part may also extend in the lateral direction beyond the perimeter of the chip, i.e., be overhanging. For example, said part may extend beyond the lateral dimensions of the top side contact. Optionally, a further, potentially thinner part of the contact layer may be arranged between the chip and the presspin body as described above with respect to the first part. These arrangements use additional space along the extension area and may allow to save space in the stacking direction for a more compact structure. Additionally, they give the opportunity to arrange more material if desired to guarantee the electrical short. The second part of the contact layer has for example an overhanging portion with respect to the chip. When viewed in the stacking direction the contact layer extends for example beyond the boundaries of the chip. Alternatively, to save more space along the extension area, the second part of the contact layer extends along the extension area within the boundaries of the chip when viewed in the stacking direction. Depending on the needed amount of material of the contact layer, the dimensions of the second part of the contact layer along the extension area and in the stacking direction can be varied, while meeting space saving requirements, and/or maintaining desired distances to neighbored terminals and/or to sidewalls of submodule.

According to a further embodiment the value of a third thickness of the second part of the contact layer in the stacking direction is smaller than or equal to the value of the first thickness.

The third thicknesses of the contact layer may be similar to the first thickness of the presspin body. The contact layer extends for example of up to 20 mm along the extension area. This facilitates the use of a larger amount of low melting material from the contact layer compared with an arrangement in the current path. In case of a short-circuit situation, the low melting conductive material of the contact layer melts and flows down to the chip, such that the conductive material is spreading over the chip surface and the sidewalls of the chip forming an electrical short or current bypass. Additionally, the comparably high amount of material is working like a phase-change heat sink, which prevents the presspin body from melting until a current bypass over the chip is formed.

Alternatively, the third thickness is larger than the first thickness. For example, in case that the contact layer is U-shaped, like a cup. The sidewalls of the U-shape extend in the stacking direction and the bottom of the U-shape extends along the extension area.

According to a further embodiment the melting point of the contact layer is lower than the melting point of any part of the pressure contact. The melting point of the contact layer is lower than the melting point of any part of the pressure contact. The melting point of the contact layer is lower than the melting point of the presspin body, the spring, the bracket or any other part of the pressure contact.

According to a further embodiment the melting point of the contact layer is lower than the melting point of the chip.

According to a further embodiment the melting point of the contact layer is above the maximum process temperature, to which the pressure contact is exposed during an assembly process. The melting point of the contact layer depends on the temperature of the assembly process to which the pressure contact is exposed, i.e., while the contact layer is present. The pressure contact is arranged after chip soldering, which is done at a comparably high melting temperature. Thus, it is avoided to expose the contact layer to unnecessary high temperatures during assembly.

According to a further embodiment the power semiconductor module comprises a confinement structure. The confinement structure is arranged on the third surface. The confinement structure extends in the stacking direction. The confinement structure surrounds the chip at least partially along the extension area.

A current bypass provided by the molten conductive material of the contact layer is formed across the top surface and one or more sidewalls of the chip in a short-circuit situation. The confinement structure avoids that the molten material is not only flowing over the chip, but also further spreading over the third main surface of the substrate surface. The confinement structure facilitates that there is a sufficient amount of material from the contact layer remaining on the chip to form a current bypass, which avoids unreliable short-circuit conditions.

The confinement structure may be realized by a frame, bond wires, or by a coating with a material, which is not wetted by the molten conductive material of the contact layer.

Alternatively, the confinement structure can be a recess, or a machined region, for example a laser irradiation of a metal surface provides a solder stop.

According to a further embodiment the power semiconductor module has a short-circuit capability for electrical currents of up to 5000 A.

According to a further embodiment the contact layer comprises metal, metal alloys, or conductive polymers.

The material of the contact layer is for example a metal, a metal alloy, or another conductive material like a conductive polymer. The material of the contact layer is for example, aluminum or aluminum alloy or lead. Alternatively, the material of the contact layer is solder or a brazing material.

According to a further embodiment the power semiconductor module comprises a preform. The preform is arranged between the pressure contact and the chip. The material of the preform is, for example, aluminum or molybdenum. In this embodiment, the contact layer may have, for example, a shape, when viewed in the stacking direction, which corresponds to the shape or outer dimensions of the preform.

There is also provided a method for creating a current bypass in the power semiconductor module. The method comprises the steps of melting the contact layer due to a short-circuit situation, for example due to elevated temperatures generated by a high current in the short-circuit situation, and exerting a gravitational force in the stacking direction towards the chip on the molten contact layer. Consequently, the molten contact layer flows over the chip. Thus, a current bypass over the chip to the substrate is created with the molten contact layer.

According to a further embodiment the method for creating a current bypass in the power semiconductor module comprises the steps of exerting with the pressure contact a pressure in the stacking direction towards the chip. Melting the contact layer due to a short-circuit situation, for example due to elevated temperatures generated by a high current in the short-circuit situation. Then, squeezing the contact layer in a molten state out due to the exerted pressure. Consequently, the molten contact layer flows over the chip. Thus, a current bypass over the chip to the substrate is created with the molten contact layer. Meanwhile, the pressure on the chip is maintained due to a spring force of the pressure contact. And an electrical connection between the pressure contact and the chip is maintained.

The present disclosure comprises several aspects of a power semiconductor module and of a method for creating a current bypass in the power semiconductor module on the basis of their embodiments and examples. Every feature described with respect to one of the aspects is also disclosed herein with respect to the other aspect, even if the respective feature is not explicitly mentioned in the context of the specific aspect. For example, the method described in this disclosure is directed to a method for creating a current bypass in a power semiconductor module. Thus, features and advantages described in connection with the power semiconductor module can be used for the method, and vice versa.

While the disclosure is amenable to various modifications and alternative forms, specifics thereof are shown by way of example in the figures and will be described in detail. It should be understood, however, that the intention is not to limit the disclosure to the particular described embodiments and examples. On the contrary, the intention is to cover all modifications, equivalents, and alternatives falling within the scope of the disclosure defined by the appended claims.

The accompanying figures are included to provide a further understanding. In the figures, elements of the same structure and/or functionality may be referenced by the same reference signs. It is to be understood that the embodiments shown in the figures are illustrative representations and are not necessarily drawn to scale.
- Figure 1 to 2: schematic cross-sectional views of a power semiconductor module,
- Figure 3 to 6: schematic cross-sectional views of a power semiconductor module according to embodiments,
- Figure 7 to 8: schematic cross-sectional views of a power semiconductor module according to embodiments with the contact layer in a melted state,
- Figure 9 to 12: schematic cross-sectional views of a power semiconductor module according to embodiments.

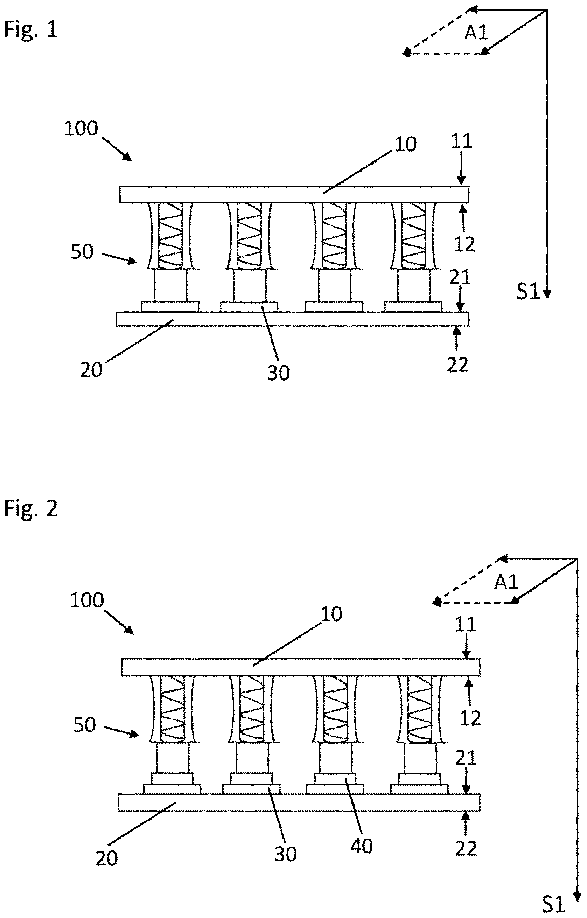

Figure 1 shows a schematic cross-sectional view of a power semiconductor module 100. The power semiconductor module 100 comprises a top plate 10. The top plate 10 extends along an extension area A1. The top plate 10 has a first main surface 11 and a second main surface 12. The second main surface 12 is opposite the first main surface 11 in (or along) a stacking direction S1, which is typically perpendicular to the main surfaces 11 and 12 of the extension area A1. The power semiconductor module 100 further comprises a substrate 20. The substrate 20 has a third main surface 21 and a fourth main surface 22. The fourth main surface 22 is opposite the third main surface 21 in the stacking direction S1. The second main surface 12 faces the third main surface 21. A chip 30 is arranged on the third main surface 21. A pressure contact 50 is arranged in the stacking direction S1 between the top plate 10 and the chip 30. In figure 1 four chips 30 and four pressure contacts 50 are shown. The power semiconductor module 100 is not limited to these numbers. The power semiconductor module 100 can comprise less than four or more than four chips 30 and pressure contacts 50. Each of the chips 30 is electrically connected to the top plate 10 by the corresponding pressure contact 50.

Figure 2 shows a schematic cross-sectional view of the power semiconductor module 100 of a further embodiment. The power semiconductor module 100 differs from the power semiconductor module 100 shown in figure 1 in that the power semiconductor module 100 comprises a preform 40. The preform 40 is arranged between the pressure contact 50 and the chip 30.

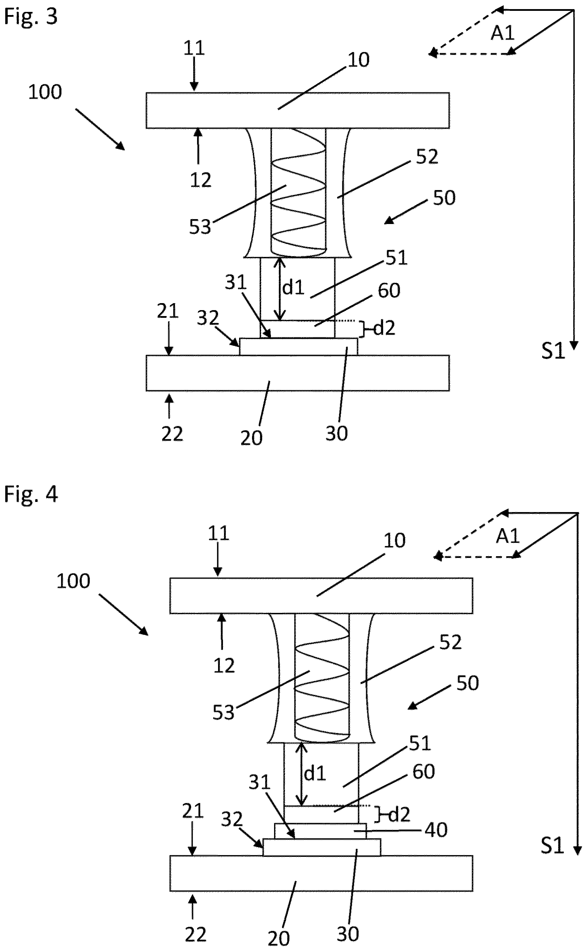

Figure 3 shows a schematic cross-sectional view of the power semiconductor module 100 of an embodiment in a more detailed view. The pressure contact 50 comprises a presspin body 51 with a first thickness d1 in the stacking direction S1. The presspin body 51 is electrically connected to the chip 30. The pressure contact 50 further comprises a bracket 52 used as current conductor. The bracket 52 is electrically connected to the presspin body 51 and the top plate 10. The pressure contact 50 further comprises a spring 53. The spring 53 applies pressure on the presspin body 51 in the stacking direction S1 towards the chip 30.

The pressure contact 50 comprises a contact layer 60. The contact layer 60 is arranged between the chip 30 and the presspin body 51. The contact layer 60 is configured to melt due to elevated temperatures generated by high current in case of a short-circuit situation. Thus, the material of the contact layer 60 is configured to flow across the chip 30 towards the third main surface 21 of the substrate 20, such that a current bypass over the chip 30 to the substrate 20 is created. Alternatively, at least the contact area on top of the high-ohmic chip 30 is significantly increased by the molten material of the contact layer 60, such that the resistance provided by the chip is at least reduced. Meanwhile, the pressure contact 50 maintains a pressure on the chip 30 due to a spring force of the pressure contact 50 and maintains an electrical connection to the chip 30. The spring 53 provides the necessary spring force.

The chip 30 has at least one top side contact 31. The top side contact 31 faces the second main surface 12. The top side contact 31 of the chip 30 is electrically connected to the top plate 10 by the pressure contact 50. Sidewalls of the 32 extend in the stacking direction S1.

The contact layer 60 has a second thickness d2 in the stacking direction S1 in a non-melted state. The value of the second thickness d2 is in the range between 5 mm and 20 mm.

Figure 4 shows a schematic cross-sectional view of the power semiconductor module 100 according to a further embodiment. The power semiconductor module 100 differs from the power semiconductor module 100 shown in figure 3 in that the power semiconductor module 100 comprises the preform 40. The preform 40 is arranged between the contact layer 60 and the chip 30.

The preform 40 is for example a metal preform, for example a molybdenum preform, which is arranged on the top side contact 31 of the chip 30. The preform 40 is in contact with the presspin body 51. It may serve, for example, for stress compensation between the chip 30 and the presspin body 51 and/or to compensate a possible tilt of the presspin body 51. In case of fail, a high temperature is generated by the short-circuit current in the affected chip 30 and terminal. Under certain conditions and for certain materials, the preform 40 may form a eutectic alloy together with the chip material, such that the chip 30 is getting conductive. Under different condition or for different materials, no eutectic alloy is formed. This is not limited by the disclosure, provided that the material of the contact layer 60 is sufficiently heated in a short-circuit situation to melt. The chip 30 may be, for example, a silicon-based chip 30.

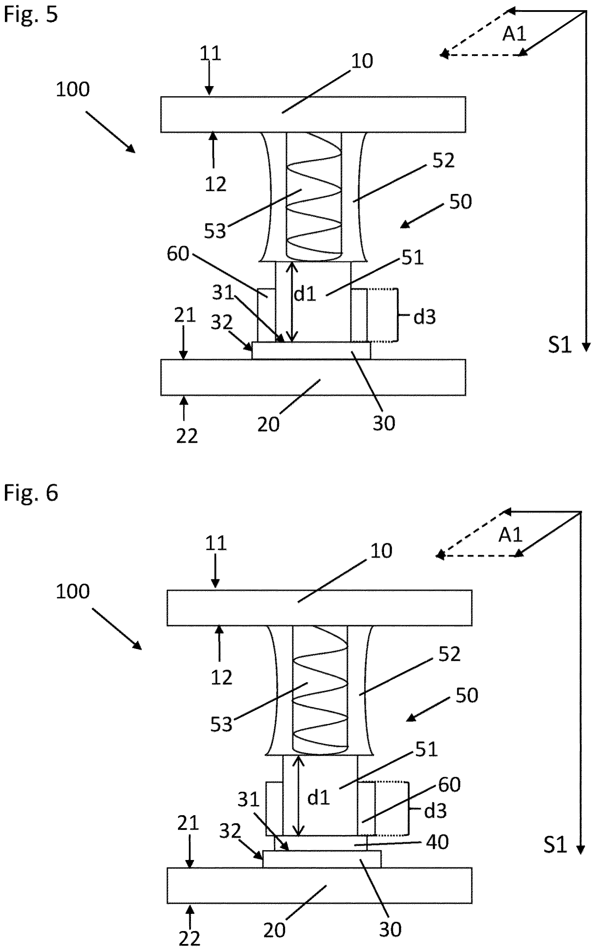

Figure 5 shows a schematic cross-sectional view of the power semiconductor module 100. The contact layer 60 is arranged along the extension area A1 in a circumferential manner around the presspin body 51. The contact layer 60 has a third thickness d3 in the stacking direction S1 in a non-melted state. The value of the third thickness d3 is smaller than or equal to the value of the first thickness d1. For example, the value of the third thickness d3 may be 5 to 20 mm. Moreover, the contact layer 60 may extend horizontally, i.e., along the extension area A1, up to a given radius or wall thickness. For example, the contact layer may have the shape of a hollow cylinder (i.e., a cylindrical shell) with a (horizontal) wall thickness of up to 15 mm. This arrangement of the contact layer 60 uses available space along the extension area A1, e.g., space available in a housing frame or to a neighboring contact, and allows to arrange more material in the contact layer compared with the previously described embodiment. It may also allow to save space in the stacking direction S1 for a more compact structure and/or to correspond to a given height limitation.

The contact layer 60 extends along the extension area A1 within the boundaries of the chip 30 when viewed in the stacking direction S1 to allow to arrange more material in the contact layer. Depending on the needed amount of material of the contact layer 60, the dimensions of the contact layer 60 along the extension area A1 and in the stacking direction S1 can be varied, while meeting space saving requirements. Alternatively, the contact layer 60 has for example an overhanging portion with respect to the chip 30. When viewed in the stacking direction S1 the contact layer 60 extends for example beyond the boundaries of the chip 30.

Figure 6 shows a schematic cross-sectional view of a further embodiment of the power semiconductor module 100. The power semiconductor module 100 differs from the power semiconductor module 100 shown in figure 5 in that the power semiconductor module 100 comprises the preform 40.

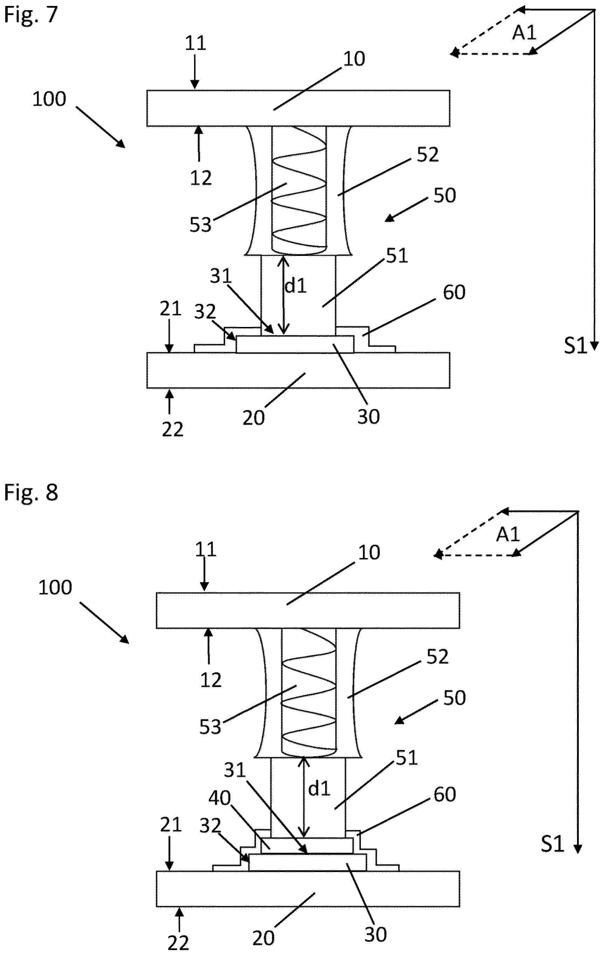

Figure 7 shows a schematic cross-sectional view of the power semiconductor module 100 according to figures 3 and 5 with a molten contact layer 60. The material of the contact layer 60 flows in its molten state across the chip 30, creating a current bypass over the chip 30 to the substrate 20. In the embodiment shown in Figure 3, due to the strong spring force of the spring 53, the molten material of the contact layer 60 is squeezed out of the terminal structure. In both embodiments, the molten material of the contact layer 60 flows over the chip 30 surface and the sidewalls of the chip 32 forming a current path, for example due to gravitational forces. In case of the embodiment shown in Fig. 3, this may also be achieved, at least in part, by squeezing the molten material of the contact layer 60 out of the terminal structure and guiding the molten material in a suitable way, such as a hollow channel formed in the power semiconductor module.

Figure 8 shows a schematic cross-sectional view of the power semiconductor module 100 with an additional preform 40 according to figures 4 and 6 with a molten contact layer 60. The material of the contact layer 60 flows in its molten state across the preform 40 and the chip 30, creating a current bypass over the chip 30 to the substrate 20.

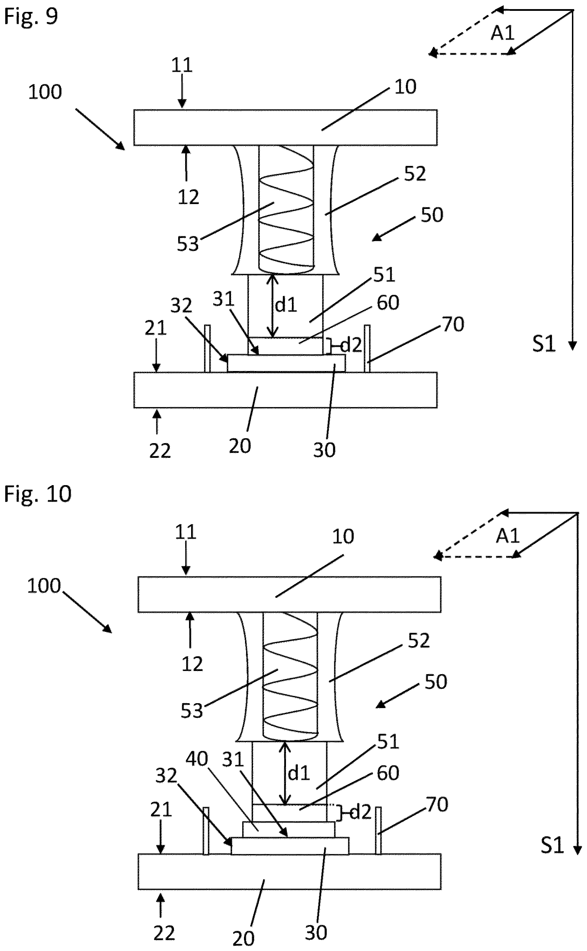

Figure 9 shows a schematic cross-sectional view of the power semiconductor module 100 according to a further embodiment. The power semiconductor module 100 comprises a confinement structure 70. The confinement structure 70 extends in the stacking direction S1 and surrounds the chip 30 at least partially along the extension area A1. The confinement structure 70 is mainly arranged on the third surface 21 of the substrate 20. The confinement structure 70 may be realized by a frame, bondwires, or by a coating with a material, which is not wetted by the molten conductive material. Alternatively, the confinement structure 70 can be a recess, or a machined region, for example a laser irradiation of a metal surface provides a solder stop.

Figure 10 shows a schematic cross-sectional view of the power semiconductor module 100 according to a further embodiment. The power semiconductor module 100 differs from the power semiconductor module 100 shown in figure 9 in that the power semiconductor module 100 comprises the preform 40.

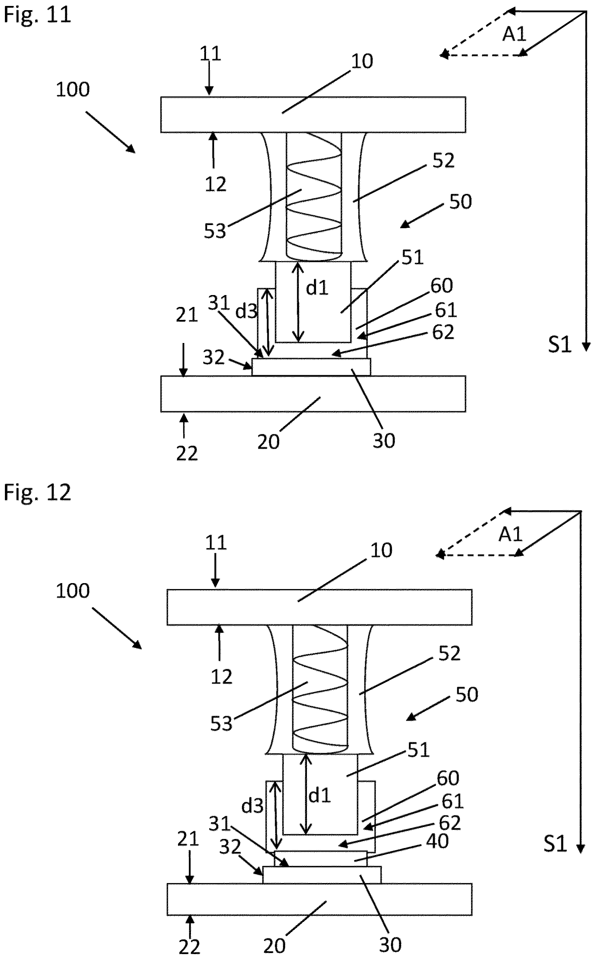

Figure 11 shows a schematic cross-sectional view of the power semiconductor module 100 of a further embodiment. The contact layer 60 has a U-shaped cross section, in which the presspin body 51 is embodied. That is to say, the contact layer 60 comprises a first part arranged between the presspin body 51 and the top surface contact 31, as described above with respect to Figures 3 and 4, and a second part surrounding the presspin body 51, as described above with respect to Figures 5 and 6.

In the described embodiment, the two parts of the contact layer 60 effectively form a cup-like structure, with a cylindrical sidewall 61 connected by a circular bottom 62. The sidewall 61 extend vertically in the stacking direction S1, and the bottom 62 extends along the extension area A1. In figure 11, the third thickness d3, i.e. a height of the sidewall 61, can be larger, equal or smaller than the first thickness d1. For example, the sidewall(s) 61 of the U-shaped contact layer 60 extend in the stacking direction S1 for 5 to 20 mm. The sidewall(s) 61 may be up to 15 mm thick in the horizontal direction. The thickness of the bottom 62 in the stacking direction S1, may be, for example, up to 15 mm. It may correspond to the thickness of the sidewall(s) 61 in the horizontal direction.

Figure 12 shows a schematic cross-sectional view of the power semiconductor module 100 of a further embodiment. The power semiconductor module 100 differs from the power semiconductor module 100 shown in figure 11 in that the power semiconductor module 100 comprises the preform 40.

The embodiments shown in the Figures 1 to 12 as stated represent exemplary embodiments of the power semiconductor module 100; therefore, they do not constitute a complete list of all embodiments according to the power semiconductor module 100. Actual arrangements and methods may vary from the embodiments shown in terms of arrangements, devices and methods for example.

### Reference Signs

- 100: power semiconductor module
- 10: top plate
- 11: first main surface
- 12: second main surface
- 20: substrate
- 21: third main surface
- 22: second main surface
- 30: chip
- 31: top surface contacts
- 32: sidewalls of chip
- 40: preform
- 50: pressure contact
- 51: presspin body
- 52: bracket
- 53: spring
- 60: contact layer
- 61: sidewall
- 62: bottom
- 70: confinement structure
- S1: stacking direction
- A1: extension area

## Claims

1. Power semiconductor module (100), comprising
- a top plate (10) extending along an extension area (A1), having a first main surface (11) and a second main surface (12) opposite the first main surface (11) in a stacking direction (S1),
- a substrate (20), having a third main surface (21) and a fourth main surface (22) opposite the third main surface (21) in the stacking direction (S1), wherein the second main surface (12) faces the third main surface (21),
- a chip (30) with at least one top side contact (31), arranged on the third main surface (21), wherein the at least one top side contact (31) faces the second main surface (12),
- a pressure contact (50) arranged in the stacking direction (S1) between the top plate (10) and the chip (30), wherein the at least one top side contact (31) of the chip (30) is electrically connected to the top plate (10) by the pressure contact (50), and wherein
- the pressure contact (50) comprises a contact layer (60) configured to melt in case of a short-circuit situation, and to flow across the chip (30), such that a current bypass over the chip (30) to the substrate (20) is created, while the pressure contact (50) maintains a pressure on the chip (30) due to a spring force of the pressure contact (50) and maintains an electrical connection to the chip (30).

2. Power semiconductor module (100) according to claim 1, wherein the pressure contact (50) comprises
- a presspin body (51) with a first thickness (d1) in the stacking direction (S1) electrically connected to the chip (30), and
- a spring (53) for applying pressure on the presspin body (51) in the stacking direction (S1) towards the chip (30).

3. Power semiconductor module (100) according to claim 2, wherein the pressure contact (50) further comprises a bracket (52) used as current conductor, which is electrically connected to the presspin body (51) and the top plate (10).

4. Power semiconductor module (100) according to claim 2 or 3, wherein a first part of the contact layer (60) is arranged between the chip (30) and the presspin body (51).

5. Power semiconductor module (100) according to any of the preceding claims, wherein the value of a second thickness (d2) of the first part of the contact layer (60) in the stacking direction (S1) is in the range between 0.5 mm and 15 mm.

6. Power semiconductor module (100) according to any of the claims 2 to 5, wherein a second part of the contact layer (60) is arranged in a circumferential manner around the presspin body (51).

7. Power semiconductor module (100) according to claim 6, wherein the value of a third thickness (d3) of the second part of the contact layer (60) in the stacking direction (S1) is smaller than or equal to the value of the first thickness (d1) .

8. Power semiconductor module (100) according to any of the preceding claims, wherein the melting point of the contact layer (60) is lower than the melting point of any part of the pressure contact (50) and/or lower than the melting point of the chip (30).

9. Power semiconductor module (100) according to any of the preceding claims, wherein the melting point of the contact layer (60) is above the maximum process temperature, to which the pressure contact (50) is exposed during an assembly process.

10. Power semiconductor module (100) according to any of the preceding claims, comprising a confinement structure (70) arranged on the third surface (21), wherein the confinement structure (70) extends in the stacking direction (S1), and surrounds the chip (30) at least partially along the extension area (A1).

11. Power semiconductor module (100) according to any of the preceding claims, wherein the power semiconductor module (100) has a short-circuit capability for electrical currents of up to 5000 A.

12. Power semiconductor module (100) according to any of the preceding claims, wherein the contact layer (60) comprises metal, metal alloys, or conductive polymers.

13. Power semiconductor module (100) according to any of the preceding claims, comprising a preform (40) arranged between the pressure contact (50) and the chip (30).

14. Method for creating a current bypass in the power semiconductor module (100) according to any of the preceding claims, comprising
- melting the contact layer (60) due to a short-circuit situation,
- exerting a gravitational force in the stacking direction (S1) towards the chip (30) on the molten contact layer (60), such that the molten contact layer (60) flows over the chip (30), and
- creating a current bypass over the chip (30) to the substrate (20) with the molten contact layer (60).

15. Method for creating a current bypass in the power semiconductor module (100) according to any of the claims 1 to 13, comprising
- exerting with the pressure contact (50) a pressure in the stacking direction (S1) towards the chip (30),
- melting the contact layer (60) due to a short-circuit situation,
- squeezing out the contact layer (60) in a molten state, such that the molten contact layer (60) flows over the chip (30), and
- creating a current bypass over the chip (30) to the substrate (20) with the molten contact layer (60), while
- maintaining the pressure on the chip (30) due to a spring force of the pressure contact (50), and
- maintaining an electrical connection to the chip (30).
